# EUROPÄISCHE PATENTSCHRIFT

(11) **EP 1 770 857 B1**
(45) Veröffentlichungstag und Bekanntmachung des Hinweises auf die Patenterteilung: **12.10.2011**
(21) Anmeldenummer: 06118851.2
(22) Anmeldetag: 14.08.2006
(51) Int. Cl.: H03G 7/00

(54) **Audioanlage mit vermindertem Klirrfaktor und Verfahren zur Verringerung des Klirrfaktors einer Audioanlage**
Audio equipment with reduced nonlinear distortion factor and method for the reduction of the nonlinear distortion factor of an audio equipment
Dispositif audio avec facteur de distortion harmonique réduit et méthode pour reduire le facteur de distortion harmonique d' un dispositif audio

(30) Priorität: 21.09.2005 DE 102005045021
(43) Veröffentlichungstag der Anmeldung: 04.04.2007
(73) Patentinhaber: ROBERT BOSCH GMBH, 70442 Stuttgart (DE)
(72) Erfinder: Montag, Christoph, 31134 Hildesheim (DE); Sahrhage, Joerg, 31139 Hildesheim (DE); Geier, Karsten, 29227 Celle (DE)

(56) Entgegenhaltungen:
- EP-A- 0 834 988
- EP-A- 1 128 549
- US-A- 4 233 566
- US-A- 5 453 716
- US-A- 5 633 940
- US-A1- 2002 090 096
- US-A1- 2002 150 266
- US-A1- 2004 081 324

## Beschreibung

Die Erfindung betrifft eine Audioanlage mit einer Klangquelle, einem Pegelbegrenzer, einem Lautstärkesteller, einem Leistungsverstärker und einer Steuereinrichtung zur Vermeidung des Klirrens sowie ein entsprechendes Verfahren zum Verringern des Klirrens der Audioanlage.

Audioanlagen wie unter anderem Autoradios, gegebenenfalls mit einem zugehörigen CD-Spieler, transportable oder feststehende Stereoanlagen, tragbare CD- oder MP3-Player oder PCs mit Lautsprechern verfügen im Allgemeinen über eine Klangquelle, beispielsweise in Form einer austauschbaren CD oder als Datenspeicher in dem Musiktitel im MP3-Format abgespeichert sind. Des Weiteren verfügen bekannte Audioanlagen über einen Pegelbegrenzer mit dem eine Signalstärke, die über einen vom Nutzer der Audioanlage zu betätigenden Lautstärkesteller an einen Leistungsverstärker zur Verstärkung des Signals weitergeleitet werden, in ihrer Stärke oder Intensität begrenzt werden kann, um das Klirren der Audioanlage, das durch Übersteuerung des Leistungsverstärkers verursacht wird, zu unterbinden. Sämtliche Funktionen der Audioanlage werden in an sich bekannter Weise von einer Steuereinrichtung überwacht und geregelt, wobei die Steuereinrichtung mit den vorstehenden beschriebenen Komponenten beispielsweise über Datenbus-Architekturen in Verbindung steht.
Dem Fachmann ist es bekannt, dass Audioanlagen häufig derart ausgelegt sind, dass bei einem voll ausgesteuerten Eingangssignal die Endstufe des Leistungsverstärkers bereits bei einer Einstellung des Lautstärkestellers auf Werte weit unterhalb des Maximums, typischerweise 10 bis 15dB, übersteuert wird. Dies hat insbesondere bei geringen Betriebsspannungen, wie sie z.B. bei Audioanlagen in Kraftfahrzeugen üblich sind, nämlich 12V Gleichstrom, den Vorteil, dass auch schwach ausgesteuerte Signale mit ausreichendem Schalldruckpegel wiedergegeben werden können. Andererseits führt die Übersteuerung der Audioanlage durch die Hochpegelsignale bei großer Verstärkung zum Abschneiden der Signalspitzen und damit zu wahrnehmbar störenden nicht linearen Signalverzerrungen.

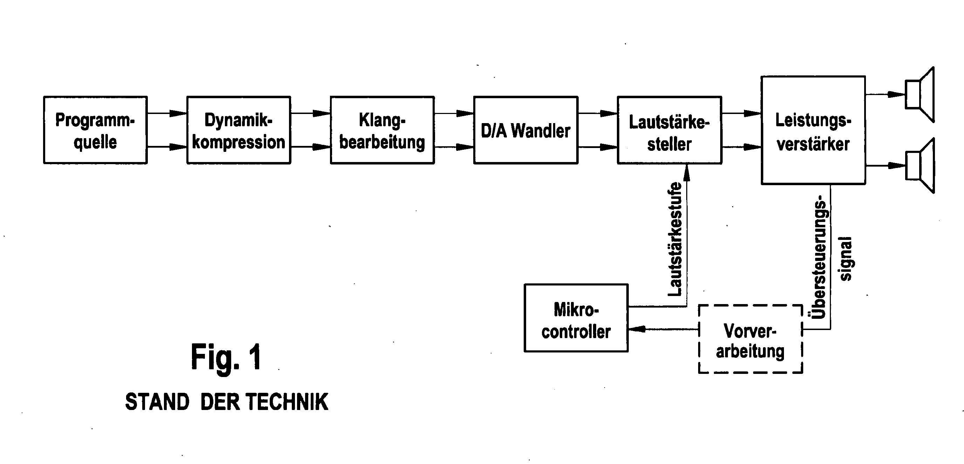

Hierzu ist es bekannt, dass von der Endstufe der Audioanlage bzw. dem Leistungsverstärker ein vorzugsweise digitales Ausgangssignal an die Steuereinrichtung übermittelt wird, falls der Leistungsverstärker übersteuert. Daraufhin wird von der Steuereinrichtung der Lautstärkesteller in seiner Einstellung schrittweise so weit reduziert, bis das Klirren auf ein erträgliches Maß zurückgegangen ist. Anschließend wird die Verstärkung mit einer relativ großen Zeitkonstante wieder schrittweise erhöht, bis der vom Nutzer vorgegebene Wert wiederum erreicht ist oder eine erneute Übersteuerung auftritt. Die Auswertung des Übersteuerungssignals kann auch frequenzabhängig durchgeführt werden. Dies kann unter Zuhilfenahme einer analogen Vorverarbeitung für das Übersteuerungssignale, deren Ausgangssignal ein Maß für das Klirren darstellt, erfolgen, so dass frequenzabhängig ein bestimmtes Klirren zugelassen werden kann. Eine Audioanlage mit einer derartigen "Anti-Clipping-Regelung" ist als Blockschaltbild in Figur 1 dargestellt und kann in kostengünstiger Weise realisiert werden.

Als nachteilig hierbei ist jedoch anzusehen, dass auf eine Übersteuerung nur mit erheblicher zeitlicher Verzögerung reagiert werden kann, da die Ansteuerung des Lautstärkestellers erst nach dem Auftreten einer Übersteuerung erfolgt.

Somit kann ein kurzzeitiges Klirren nicht unterbunden werden. Des Weiteren wird aufgrund der relativ großen Zeitkonstanten die maximal mögliche mittlere Ausgangsleistung besonders bei stark impulshaltigen Musiktiteln nicht voll ausgeschöpft.

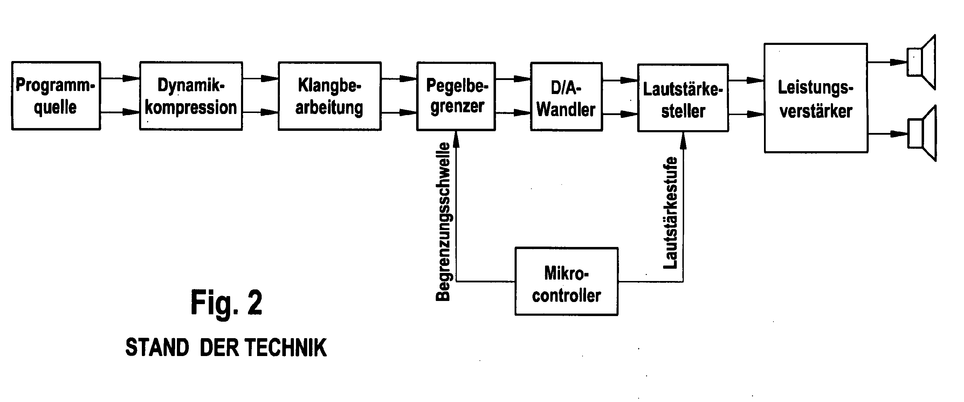

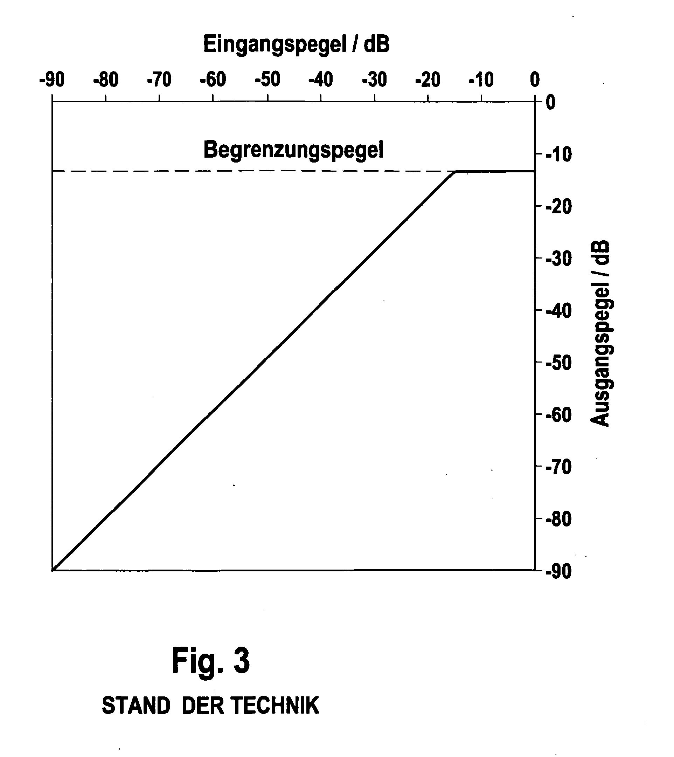

Weiterhin ist es zum Vermeiden des Klirrens bekannt, dass eine Audioanlage mit einem Pegelbegrenzer (engl.: "limiter") ausgestattet ist. Eine derartige Audioanlage ist als Blockschaltbild in Figur 2 schematisch wiedergegeben. Der Pegelbegrenzer ist hier dem Lautstärkesteller vorgeschaltet und arbeitet mit wesentlich kleineren Zeitkonstanten und einer höheren Pegelauflösung, um die Verstärkung des Audiosignals im Bedarfsfall kurzzeitig abzuregeln. Der Pegelbegrenzer wird abhängig von der vom Nutzer eingestellten Lautstärkestufe so parametriert, dass Signalspitzen oberhalb eines Pegels, der zur Übersteuerung der Endstufe führen würde, auf eben diesen Pegel abgeregelt werden. Dies ist dem Diagramm in Figur 3 entnehmbar. Mit diesem schnellen Kompressionsverhalten kann der Leistungsverstärker dicht an seiner Aussteuerungsgrenze betrieben werden. Weiterhin kann ein digitaler Pegelbegrenzer das Nutzsignal zwischen der Pegelmessung und der Signalskalierung zeitlich verzögern, so dass durch eine rechtzeitige Verringerung der Verstärkung eine Übersteuerung des Ausgangssignals zuverlässig vermieden werden kann.

Als nachteilig hierbei ist jedoch anzusehen, dass stets eine gewisse Dynamikreserve verbleiben muss, um alle Übersteuerungssituationen zuverlässig ausschließen zu können. Somit kann das Leistungsspektrum der Audioanlage nicht vollständig ausgeschöpft werden.

Die US 5,633,940_beschreibt eine Audio-Verstärkungseinrichtung mit einem Eingang 1 zum Empfang eines Audiosignals. Dem nachgeschaltet ist eine Verstärkerstufe 2 und eine Ausgangsverstärkerstufe 3. Dabei kann die Verstärkerstufe 2 entweder die Lautstärke insgesamt, über den gesamten Frequenzbereich, verstärken oder nur der "Bassbereich" oder nur der "Höhenbereich" (engl.: treble) auf Basis des Übersteuerungssignals der Ausgangsverstärkerstufe 3. Weiterhin ist ein Steuerungsschaltkreis 5 vorgesehen, um die Lautstärke insgesamt, den Bassbereich oder den Höhenbereich in Abhängigkeit von Steuervorgaben eines Nutzers zu regeln. Eine selbsttätige Regelung durch den Steuerungsschaltkreis 5 erfolgt nicht. Es erfolgt lediglich eine Verringerung der Signalstärke des Audiosignals, das durch die Verstärkerstufe 2 verstärkt worden ist, durch den Steuerungsschaltkreis 5 in Abhängigkeit von der vorgewählten Lautstärkeeinstellung und/oder der Basseinstellung und/oder der Höheneinstellung.

Die US 2004/081324 A1 offenbart bereits eine Audioanlage mit einer Klangquelle, einem Pegelbegrenzer, einem Lautstärkesteller, einem Leistungsverstärker und einer Steuereinrichtung zur Vermeidung des Klirrens, wobei der Pegelbegrenzer von der Steuereinrichtung in Abhängigkeit eines Übersteuerungssignals des Leistungsverstärkers ansteuerbar ist und die Steuereinrichtung den Pegelbegrenzer in Abhängigkeit eines Aktivitätssignals des Pegelbegrenzers ansteuert.

Ausgehend von diesem Stand der Technik liegt der Erfindung die Aufgabe zugrunde, eine Audioanlage der Eingangs genannten Art zu schaffen, die verzerrungsarm mit einer möglichst großen mittleren Ausgangsleistung betrieben werden kann.

Der Vorteil der Erfindung besteht darin, dass die Audioanlage praktisch keinen zusätzlichen konstruktiven Aufwand erfordert, da eine Steuereinrichtung üblicherweise bereits vorhanden ist. Diese kann in einfacher Weise hard- und/oder softwaremäßig vom Fachmann derart ausgestaltet werden, dass das Verfahren durchgeführt werden kann.

Beim Betrieb der Audioanlage wird entsprechend der vom Nutzer am Lautstärkesteller eingestellten Lautstärke ein Signal von der Programmquelle über den Pegelbegrenzer und den Lautstärkesteller dem Leistungsverstärker zugeleitet. Solange sich die eingestellte Lautstärke in einem Bereich befindet, in dem laut des Pegelplans des Audiowiedergabesystems keine Übersteuerung des Leistungsverstärkers auftreten kann, wird die Begrenzungsschwelle des Pegelbegrenzers auf den Maximalwert gesetzt, so dass dieser praktisch überbrückt ist. Wird hingegen der Lautstärkesteller auf einen derartigen Wert eingestellt, bei dem im Falle eines Vollpegelsignals eine Übersteuerung des Leistungsverstärkers auftreten könnte, wird im Gegenzug der Begrenzungspegel des Pegelbegrenzers durch die Steuereinrichtung zunächst derart abgesenkt, dass der Ausgangspegel die Übersteuerungsgrenze nicht überschreiten kann. Auf diese Weise wird der Pegelbegrenzer aktiviert und beginnt, Signalpegelspitzen auf den Begrenzungspegel selbstständig abzuregeln.

Vorteilhafte Ausgestaltungen der Erfindung sind jeweils in den Unteransprüchen gekennzeichnet.

Nachfolgend kann, wie in den Ansprüchen 2 und 6 ausgeführt, von der Steuereinrichtung mit einer sehr großen Zeitkonstante, beispielsweise in einer Größenordnung von 1db pro Minute, der Begrenzungspegel des Pegelbegrenzers wiederum schrittweise angehoben, bis wiederum die obere Einstellgrenze, die unter Ausnutzung aller Bauteil- und Spannungstoleranzen noch eine unverzerrte Wiedergabe eines Vollpegelsignals ermöglichen könnte, erreicht ist oder bis der Leistungsverstärker erneut eine Übersteuerung anzeigt. In diesem Fall wird von der Steuereinrichtung im Gegensatz zum Stand der Technik nicht die Einstellung des Lautstärkestellers sondern der Begrenzungspegel des Pegelbegrenzers so lange verringert, bis die Übersteuerung vorüber ist. Dies erfolgt mit einer weitaus geringeren Zeitkonstante als das vorstehend beschriebene Anheben des Begrenzungspegels. Dieser Vorgang kann unter Umständen einen erhöhten Rechenaufwand in der Steuereinrichtung erfordern. Schließlich wird der Begrenzungspegel wiederum langsam mit einer großen Zeitkonstante angehoben, bis gegebenenfalls der vorstehend beschriebene Regelzyklus erneut durchlaufen wird.

Dies hat den Vorteil, dass die Audioanlage mit der maximal möglichen Ausgangsleistung betrieben werden kann und dennoch eine verzerrungsarme Wiedergabe ermöglicht ist.

Zur Verbesserung des Regelverhaltens der Audioanlage ist in den Ansprüchen 3 und 8 vorgeschlagen, dass von dem Pegelbegrenzer ein Aktivitätssignal an die Steuereinrichtung zurückübermittelt wird. Somit muss die Steuereinrichtung nur dann Signale an den Pegelbegrenzer übermitteln bzw. diesen nachregeln, wenn der Pegelbegrenzer das Audiosignal auch tatsächlich limitiert. Sollte gleichzeitig auch der Leistungsverstärker eine Übersteuerung anzeigen, wird von der Steuereinrichtung der Begrenzungspegel des Pegelbegrenzers in kleinen Schritten abgesenkt, ansonsten kann dieser wieder angehoben werden. Dies kann mit einer einheitlichen, relativ großen Zeitkonstante vorgenommen werden, um den Leistungsverstärker auch bei Hochpegelsignalen ständig unmittelbar an seiner Aussteuergrenze betreiben zu können. Somit greift der Pegelbegrenzer nicht mehr als unbedingt notwendig in das Audiosignal ein und Übersteuerungen können nur kurzzeitig und nur in sehr geringem Umfang auftreten.

Des Weiteren ist in den Ansprüchen 4 und 9 vorgeschlagen, dass das Übersteuerungssignal des Leistungsverstärkers einer Vorverarbeitung unterzogen wird, um die Größe der tatsächlichen Verzerrung bzw. die Größe des Klirrfaktors zu ermitteln. Dies kann in einem separaten Bauteil der Audioanlage erfolgen, das aber auch in die Steuereinrichtung integriert sein kann. Somit kann ein geringfügiges Klirren, das insbesondere unterhalb einer einstellbaren Höchstgrenze liegt, zugelassen werden. Sobald das tatsächliche Klirren zu stark wird kann der Begrenzungspegel des Pegelbegrenzers von der Steuereinrichtung entsprechend nachreguliert werden.

Ebenso ist es, wie in den Ansprüchen 5 und 10 angegeben, möglich, dass anstelle des Übersteuerungssignals des Leistungsverstärkers dessen Betriebsspannung von der Steuereinrichtung überwacht wird. Anhand der Betriebsspannung kann, wie es dem Fachmann bekannt ist, der momentane Übersteuerungsgrenzpegel des Leistungsverstärkers ermittelt werden und anhand des bekannten Pegelplans derjenige Begrenzungspegel des Pegelbegrenzers ermittelt werden, der notwendig ist, um das festgestellte Übersteuern zu unterbinden. Dies erfolgt allerdings ohne eine Berücksichtigung von technisch bedingten Bauteiltoleranzen der Komponenten, da ansonsten jede einzelne Audioanlage einem Testlauf zur Ermittlung des Pegelplans unterzogen werden müsste.

Eine Ausführungsform der Erfmdung wird nachstehend anhand der Zeichnungen näher erläutert. Es zeigen in schematischen Darstellungen:
- Fig. 1:: eine Audioanlage im Blockschaltbild aus dem Stand der Technik,
- Fig. 2:: eine weitere Audioanlage im Blockschaltbild aus dem Stand der Technik,
- Fig. 3:: eine statische Kennlinie eines Pegelbegrenzers,
- Fig. 4:: eine erfindungsgemäße Audioanlage im Blockschaltbild, und
- Fig. 5:: eine weitere erfindungsgemäße Audioanlage im Blockschaltbild

In den Figuren 1 und 2 sind jeweils als schematisches Blockschaltbild Audioanlagen aus dem Stand der Technik beschrieben, bei denen, wie vorstehend ausgeführt, entweder durch ein Übersteuerungssignal des Leistungsverstärkers oder durch einen zusätzlich vorgesehenen Pegelbegrenzer das Klirren unterbunden wird. Hierzu ist in Figur 3 die Begrenzung des maximal zulässigen Signalpegels mit einem Pegelbegrenzer dargestellt.

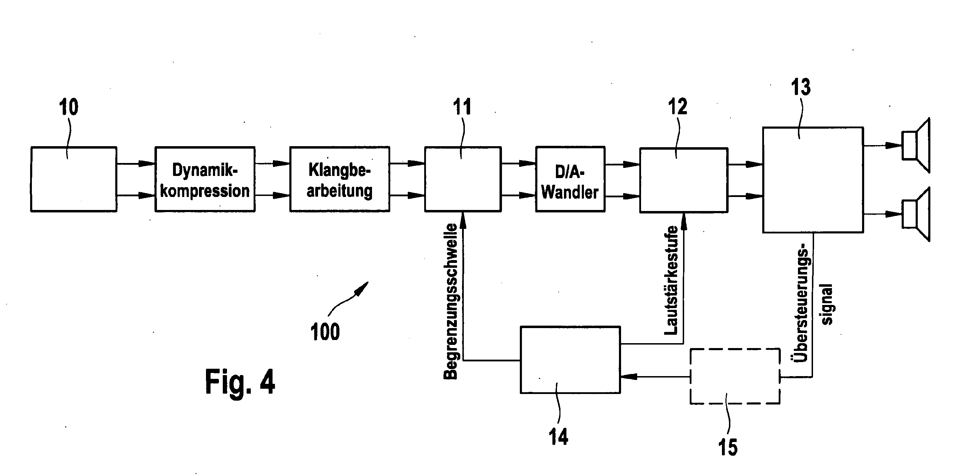

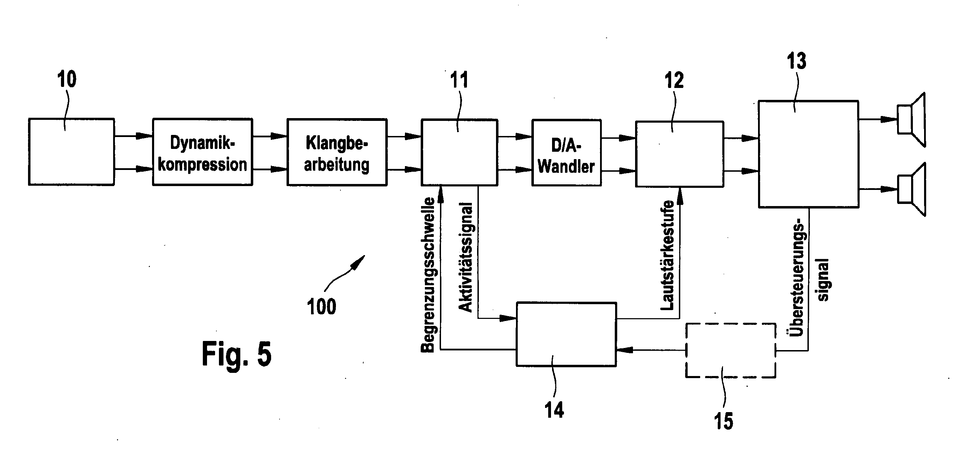

Aus den Darstellungen der Figuren 4 und 5 lässt sich jeweils eine Audioanlage 100 entnehmen, die bei maximal möglichem Signalpegel dennoch im Wesentlichen klirrfrei betrieben werden kann. Die Audioanlage 100 aus Figur 4 umfasst neben den weiteren dem Fachmann bekannten Komponenten unter anderem eine Klangquelle 10, beispielsweise eine austauschbare CD oder einen Datenspeicher mit z.B. im MP3-Format abgespeicherten Musiktiteln. Zur Begrenzung eines Signalpegels dient in an sich bekannter Weise ein Pegelbegrenzer 11, der einem Lautstärkesteller 12, der vom Nutzer in gewünschter Weise eingestellt wird, vorgeschaltet ist. Anhand dieses Lautstärkestellers 12 wird das aus der Klangquelle 10 kommende Signal in gewünschter Weise vom Leistungsverstärker 13 verstärkt und den hier symbolisch dargestellten Lautsprechern zugeführt. Sämtliche Funktionen der Audioanlage 100 werden von einer Steuereinrichtung 14 überwacht.

Sobald der Leistungsverstärker übersteuert, d.h., dass ein Klirren hörbar wird, sendet er ein vorzugsweise digitales Übersteuerungssignal an die Steuereinrichtung 14, die daraufhin den Begrenzungspegel des Pegelbegrenzers 11 nach unten setzt, um das Klirren zu unterbinden. Da die Übersteuerung im Gegensatz zum Stand der Technik nur in weitaus geringerem Umfang auftreten kann, tritt das Klirren weniger in Erscheinung und wird zudem wesentlich schneller unterbunden. Der Lautstärkesteller wird hierzu nicht reduziert. Die Wirkverbindungen zwischen den einzelnen Komponenten der Audioanlage 100 sind hier schematisch durch die Pfeile angedeutet. Dabei ist es auch möglich, dass das Übersteuerungssignal des Leistungsverstärkers 13 einer Vorverarbeitung gegebenenfalls in einer eigenen Einrichtung 15 unterzogen wird, um beispielsweise ein geringfügiges Klirren, das praktisch nicht hörbar ist, zuzulassen.

In Figur 5 ist eine Audioanlage 100 abgebildet, die im Wesentlichen den gleichen Aufbau aufweist wie die Audioanlage 100 in Figur 4. Zusätzlich wird vom Pegelbegrenzer 11 ein Rückmeldungssignal an die Steuereinrichtung 14 übermittelt, das anzeigt, dass der Pegelbegrenzer 11 momentan aktiv ist, d.h. den Signalpegel reduziert hat. Somit kann die Steuereinrichtung 14 in der Zeit, in der kein Rückmeldungssignal vom Pegelbegrenzer 11 kommt, von unnötigem Rechenaufwand entlastet werden.

## Patentansprüche

1. Audianlage (100) mit eine Klangquelle (10), einem Pegelbegrenzer (11), der Kompressionsverhalten zeigt, mit dem Spitzenwerte oberhalb eines Pegels abgeregelt werden, einem Lautstärkesteller (12), einem Leistungsverstärker (13) und einer Steuereinrichtung (14) zur Vermeidung des Klirrens, wobei der Pegelbegrenzer (11) von der Steuereinrichtung (14) in Abhängigkeit eines Übersteuerungssignals des Leistungsverstärkers (13) ansteuerbar ist und die Steuereinrichtung (14) den Pegelbegrenzer (11) in Abhängigkeit eines Aktivitätssignals des Pegelbegrenzers (11) ansteuert.

2. Audioanlage nach Anspruch 1, **dadurch gekennzeichnet, dass** ein Begrenzungspegel des Pegelbegrenzers (11) anhebbar ist, insbesondere mit einer großen Zeitkonstante.

3. Audioanlage nach einem der Ansprüche 1 oder 2, **dadurch gekennzeichnet, dass** das Übersteuerungssignal des Leistungsverstärkers (13) einer Vorverarbeitung unterziehbar ist, um einen geringen Klirrfaktor zuzulassen.

4. Audioanlage nach einem der Ansprüche 1 bis 3, **dadurch gekennzeichnet, dass** eine Betriebsspannung des Leistungsverstärkers (13) überwachbar ist.

5. Verfahren zum Betreiben einer Audioanlage mit einer Klangquelle, einem Pegelbegrenzer (11) der Kompressionsverhalten zeigt, mit dem Spitzenwerte oberhalb eines Pegels abgeregelt werden, einem Lautstärkesteller (12), einem Leistungsverstärker (13) und einer Steuereinrichtung (14) zur Vermeidung des Klirrens, wobei der Pegelbegrenzer (11) von der Steuereinrichtung (14) in Abhängigkeit eines Übersteuerungssignals des Leistungsverstärkers (13) angesteuert wird und der Pegelbegrenzer (11) von der Steuereinrichtung (14) in Abhängigkeit eines Aktivitätssignals des Pegelbegrenzers (11) angesteuert wird.

6. Verfahren nach Anspruch 6, **dadurch gekennzeichnet, dass** ein Begrenzungspegel des Pegelbegrenzers (11) angehoben wird, insbesondere mit einer großen Zeitkonstante.

7. Verfahren nach einem der Ansprüche 5 oder 6, **dadurch gekennzeichnet, dass** das Übersteuerungssignal des Leistungsverstärkers (13) einer Vorverarbeitung unterzogen wird, um einen geringen Klirrfaktor zuzulassen.

8. Verfahren nach einem der Ansprüche 5 bis 7, **dadurch gekennzeichnet, dass** eine Betriebsspannung des Leistungsverstärkers (13) überwacht wird.

## Claims

1. Audio installation (100) having a sound source (10), a limiter (11) which exhibits compression behaviour, which is used to limit peak values above a level, a volume control (12), a power amplifier (13) and a control device (14) for preventing non-linear distortion, wherein the limiter (11) can be actuated by the control device (14) on the basis of an overdrive signal from the power amplifier (13), and the control device (14) actuates the limiter (11) on the basis of an activity signal from the limiter (11).

2. Audio installation according to Claim 1, **characterized in that** a limiting level for the limiter (11) can be raised, particularly using a large time constant.

3. Audio installation according to one of Claims 1 and 2, **characterized in that** the overdrive signal from the power amplifier (13) can be subjected to preprocessing in order to permit low total harmonic distortion.

4. Audio installation according to one of Claims 1 to 3, **characterized in that** an operating voltage for the power amplifier (13) can be monitored.

5. Method for the operation of an audio installation having a sound source, a limiter (11) which exhibits compression behaviour, which is used to limit peak values above a level, a volume control (12), a power amplifier (13) and a control device (14) for preventing non-linear distortion, wherein the limiter (11) is actuated by the control device (14) on the basis of an overdrive signal from the power amplifier (13), and the limiter (11) is actuated by the control device (14) on the basis of an activity signal from the limiter (11).

6. Method according to Claim 5, **characterized in that** a limiting level for the limiter (11) is raised, particularly using a large time constant.

7. Method according to one of Claims 5 and 6, **characterized in that** the overdrive signal from the power amplifier (13) is subjected to preprocessing in order to permit low total harmonic distortion.

8. Method according to one of Claims 5 to 7, **characterized in that** an operating voltage for the power amplifier (13) is monitored.

## Revendications

1. Équipement audio (100) comprenant une source de son (10), un limiteur de niveau (11) qui présente un comportement de compression avec lequel les valeurs de crête au-dessus d'un certain niveau sont écrêtées, un élément de réglage du volume (12), un amplificateur de puissance (13) et un dispositif de commande (14) pour éviter la distorsion harmonique, le limiteur de niveau (11) pouvant être commandé par le dispositif de commande (14) en fonction d'un signal de saturation de l'amplificateur de puissance (13) et le dispositif de commande (14) commandant le limiteur de niveau (11) en fonction d'un signal d'activité du limiteur de niveau (11).

2. Équipement audio selon la revendication 1, **caractérisé en ce qu'**un niveau de limitation du limiteur de niveau (11) peut être relevé, notamment avec une constante de temps élevée.

3. Équipement audio selon l'une des revendications 1 ou 2, **caractérisé en ce que** le signal de saturation de l'amplificateur de puissance (13) peut être soumis à un prétraitement afin d'autoriser un facteur de distorsion harmonique plus faible.

4. Équipement audio selon l'une des revendications 1 à 3, **caractérisé en ce qu'**il est possible de surveiller une tension de service de l'amplificateur de puissance (13).

5. Procédé de fonctionnement d'un équipement audio comprenant une source de son, un limiteur de niveau (11) qui présente un comportement de compression avec lequel les valeurs de crête au-dessus d'un certain niveau sont écrêtées, un élément de réglage du volume (12), un amplificateur de puissance (13) et un dispositif de commande (14) pour éviter la distorsion harmonique, le limiteur de niveau (11) étant commandé par le dispositif de commande (14) en fonction d'un signal de saturation de l'amplificateur de puissance (13) et le limiteur de niveau (11) étant commandé par le dispositif de commande (14) en fonction d'un signal d'activité du limiteur de niveau (11).

6. Procédé selon la revendication 5, **caractérisé en ce qu'**un niveau de limitation du limiteur de niveau (11) est relevé, notamment avec une constante de temps élevée.

7. Procédé selon l'une des revendications 5 ou 6, **caractérisé en ce que** le signal de saturation de l'amplificateur de puissance (13) est soumis à un prétraitement afin d'autoriser un facteur de distorsion harmonique plus faible.

8. Procédé selon l'une des revendications 5 à 7, **caractérisé en ce qu'**une tension de service de l'amplificateur de puissance (13) est surveillée.
